# EUROPÄISCHE PATENTSCHRIFT

(11) **EP 3 138 162 B1**
(45) Veröffentlichungstag und Bekanntmachung des Hinweises auf die Patenterteilung: **24.05.2023**
(21) Anmeldenummer: 15723151.5
(22) Anmeldetag: 29.04.2015
(51) Int. Cl.: H01R 12/70, H01R 25/16, H05K 1/02, H01R 12/58

(54) **ELEKTRISCHE HOCHSTROMSCHALTUNG MIT EINER LEITERPLATTE UND EINER STROMSCHIENE**
HIGH-CURRENT ELECTRICAL CIRCUIT HAVING A CIRCUIT BOARD AND A BUS BAR
CIRCUIT ÉLECTRIQUE HAUTE INTENSITÉ COMPORTANT UNE CARTE DE CIRCUITS IMPRIMÉS ET UNE BARRE OMNIBUS

(30) Priorität: 30.04.2014 DE 102014006360
(43) Veröffentlichungstag der Anmeldung: 08.03.2017
(73) Patentinhaber: Ellenberger & Poensgen GmbH, 90518 Altdorf (DE)
(72) Erfinder: ULLERMANN, Wolfgang, 91126 Schwabach (DE); ENGEWALD, Manuel, 90411 Nürnberg (DE); MIKLIS, Markus, 90592 Pfeifferhütte (DE)
(74) Vertreter: FDST Patentanwälte
(86) Internationale Anmeldenummer: PCT/EP2015/059280
(87) Internationale Veröffentlichungsnummer: WO 2015/165932

(56) Entgegenhaltungen:
- EP-A1- 2 330 865
- EP-A2- 1 291 983
- EP-B1- 0 590 643
- DE-A1-102009 019 699
- US-A- 5 263 247
- US-A1- 2014 000 960
- US-B1- 8 469 724

## Beschreibung

Die Erfindung betrifft eine elektrische Schaltung mit einer Leiterplatte, auf dem eine Anzahl elektrischer und/oder elektronischer Bauelemente montiert ist.

Nutzfahrzeuge, z. B. Kühllaster, weisen elektrisch betriebene Nebenaggregate auf, wie insbesondere eine Kühlanlage oder Hebebühnen. Für den Betrieb ist daher ein Schalten des das jeweilige Aggregat versorgenden Stromkreises erforderlich, was üblicherweise mittels Leistungshalbleiterschaltern erfolgt. Das Bordnetz von Nutzfahrzeugen weist eine elektrische Spannung von 24 V auf. Um auch vergleichsweise leistungsstarke Nebenaggregate zu versorgen, ist es daher erforderlich, vergleichsweise große Ströme zu schalten. Hierfür werden üblicherweise Hochstromleiterplatten verwendet, die Leiterzwischenschichten in Dickkupfertechnik aufweisen, mit denen die Leistungshalbleiter elektrisch kontaktiert sind. Die Dicke dieser Kupferschichten beträgt bis zu 400 µm. Die Kosten zur Herstellung derartiger Leiterplatten sind vergleichsweise hoch.

Aus der EP 0 590 643 B1 ist eine Hochstromleiterplattenanordnung bekannt, die eine Leiterplatte sowie eine Sammelschiene aufweist, die von der Leiterplatte beabstandet ist. Mittels der Sammelschiene erfolgt die Bestromung von Befestigungselementen der Leiterplatte.

Aus EP 2 330 865 A1 ist eine Steuervorrichtung bekannt, die mit einer Stromschiene bestückt ist. Die Stromschiene ist kammartig ausgeschnitten und weist drei Stege auf.

Aus EP 1 291 983 A2 ist eine Anschlusseinheit bekannt, die von einem Schaltungsträger getrennte Stromschienen aufweist. Die Anschlusseinheit wird beispielsweise in einem Kraftfahrzeug eingesetzt.

Aus US 8,469,724 B1 ist ein Arbeitsspeichermodul bekannt, das eine Stromschiene aufweist. Die Stromschiene ist beispielsweise aus einer Kupferaluminiumlegierung erstellt.

Aus US 5,263,247 A sind unterschiedliche Arten einer Befestigung einer Stromschiene mittels eines Halteelements an einer Leiterplatte offenbart. Hierbei wird stets ein Halteelement mit einem Kragen durch eine Öffnung der Leiterplatte gesteckt und dort zusammen mit der Stromschiene kraftschlüssig fixiert.

Aus DE 10 2009 01969 A1 ist eine Anschlussklemme zum elektrischen Kontaktieren und zum Anbringen an eine Leiterplatte für wenigstens einen elektrischen Leiter bekannt, die aus einem mehrfach gebogenen Kontaktträger und einem Federteil besteht.

Aus US 2014/0000960 A1 ist eine aus einer Metallplatte gestanzte Sammelschiene bekannt. Die Sammelschiene umfasst einen Stromeingangsabschnitt, in den der Strom eingeleitet wird, einen stimmgabelförmigen Anschluss, in den ein Relaisanschluss eingeführt wird, eine Vielzahl von Substrat-Anschlussabschnitten, die an einer Leiterplatte angelötet sind, und einen Leitungsführungsabschnitt.

Der Erfindung liegt die Aufgabe zugrunde, eine besonders geeignete elektrische Schaltung anzugeben, die geeigneterweise kostengünstig herstellbar und vorteilhafterweise auf unterschiedlichste Anforderungen anpassbar ist.

Diese Aufgabe wird erfindungsgemäß durch die Merkmale des Anspruchs 1 gelöst. Vorteilhafte Weiterbildungen und Ausgestaltungen sind Gegenstand der Unteransprüche.

Die elektrische Schaltung weist eine, insbesondere plattenförmige, Leiterplatte auf, die beispielsweise aus faserverstärktem Kunststoff mit Leiterbahnen aus insbesondere Kupfer besteht. Die Schichtstärke der Leiterbahnen ist geeigneterweise kleiner 140 µm, 70 µm und beispielsweise kleiner oder gleich 35 µm. Mit anderen Worten ist keine der Leiterbahnen der Leiterplatte dicker als 35 µm. Zweckmäßigerweise befinden sich die Leiterbahnen lediglich auf einer Seite des als Platte ausgeführten Kunststoffkörpers, im Folgenden auch als Kunststoffplatte bezeichnet, oder auf deren beiden Oberflächen. Zweckmäßigerweise weist die Leiterplatte keine leitfähige Zwischenschicht auf. Insbesondere ist die Leiterplatte Kupferzwischenschichtlos. Auf der Leiterplatte ist eine Anzahl elektrischer und/oder elektronischer Bauelemente montiert, die insbesondere jeweils mit einer der Leiterbahnen elektrisch kontaktiert sind. Vorteilhafterweise sind die elektrischen bzw. elektronischen Bauelemente in direktem mechanischem Kontakt mit einer der Leiterbahnen, die sich auf der Oberfläche der Kunststoffplatte befinden. Unter elektrischem Bauelement wird insbesondere der kleinste grundlegende, als Einheit betrachtete Bestandteil einer elektrischen Schaltung verstanden, wie z. B. passive oder aktive Bauelemente. Insbesondere werden unter elektrischen Bauelementen Widerstände, Kondensatoren, Induktivitäten, Dioden, Transistoren, Optokoppler oder Relais verstanden. Geeigneterweise umfassen die auf der Leiterplatte montierten Bauelemente zumindest einen Halbleiter, der insbesondere ein Transistor und vorteilhafterweise ein MOSFET oder ein IGBT ist. Unter elektronischem Bauelement wird insbesondere eine elektrische Schaltung verstanden, die beispielsweise diskret oder integriert als Chip ausgeführt ist.

Die elektrische Schaltung umfasst ferner eine Stromschiene mit einem Tragkörper und mit einem ersten Anschluss sowie mit einem zweiten Anschluss als auch mit einem dritten Anschluss. Der Tragkörper ist zur Leiterplatte beabstandet und ist beispielsweise parallel zu dieser angeordnet. Mit anderen Worten ist der Abstand zur im Wesentlichen plattenförmigen Leiterplatte konstant. Der geringste Abstand zwischen dem Tragkörper und der Leiterplatte verläuft zweckmäßigerweise senkrecht zur Leiterplatte. Beispielsweise sind sämtliche elektrischen/elektronischen Bauelemente an einer der Seiten der Leiterplatte montiert, und die Stromschiene befindet sich ebenfalls auf dieser Seite. Vorteilhafterweise ist hierbei zumindest eines der Bauelemente zwischen dem Tragkörper und der Leiterplatte angeordnet. Auf diese Weise ist dieses Bauelement vor Beschädigungen geschützt. Ferner ist eine Montage der elektrischen Schaltung in einem Gehäuse erleichtert. Alternativ hierzu befindet sich die Stromschiene auf der gegenüberliegenden Seite, so dass die Leiterplatte zwischen den Bauelementen und dem Tragkörper angeordnet ist. Somit werden die Bauelemente von der Stromschiene vergleichsweise wenig beeinflusst.

Der Tragkörper und die Anschlüsse bestehen aus einem elektrisch leitfähigen Material, und jeder der Anschlüsse ist sowohl mit dem Tragkörper als auch mit der Leiterplatte elektrisch kontaktiert. Insbesondere sind die Anschlüsse sowohl an dem Tragkörper als auch an der Leiterplatte direkt angebunden, also in direktem mechanischen Kontakt. Beispielsweise ist jeder der Anschlüsse mit einer Leiterbahn elektrisch kontaktiert, die auf einer Oberfläche der Kunststoffplatte der Leiterplatte angebracht ist. Geeigneterweise sind die Leiterbahnen, die jedem der Anschlüsse zugeordnet sind, elektrisch gegeneinander isoliert oder zumindest mittels mindestens einem der elektrischen oder elektronischen Bauelemente elektrisch verbunden. Mit anderen Worten sind die Leiterbahnen nicht kurz geschlossen.

Die Kontaktstellen der Anschlüsse mit dem Tragkörper sind jeweils zueinander beabstandet, wobei die Kontaktstellen vorzugsweise entlang einer Geraden angeordnet sind. Hierbei ist der erste Anschluss benachbart zu dem zweiten Anschluss und der dritte Anschluss benachbart zu dem zweiten Anschluss angeordnet. In Stromflussrichtung entlang der Stromschiene und/oder räumlich befindet sich der zweite Anschluss zwischen dem ersten Anschluss und dem dritten Anschluss. Der Tragkörper weist zwischen dem ersten Anschluss und dem zweiten Anschluss einen ersten Querschnitt und zwischen dem zweiten Anschluss und dem dritten Anschluss einen zweiten Querschnitt auf, wobei der erste Querschnitt kleiner als der zweite Querschnitt ist. Mit anderen Worten ist die Fläche des zweiten Querschnitts größer als die Fläche des ersten Querschnitts. Insbesondere wird hierfür lediglich die Fläche herangezogen, die mit Material befüllt ist, also geeigneterweise der Teil des Tragkörpers, der massiv ausgeführt ist. Beispielsweise ist die Form des ersten Querschnitts gleich der Form des zweiten Querschnitts, wobei sich der Maßstab unterscheidet. Mit anderen Worten ist der zweite Querschnitt gleich dem ersten Querschnitt, der in zumindest einer Dimension vergrößert ist.

Der jeweilige Querschnitt wird hierbei senkrecht zur kürzesten Verbindung und/oder senkrecht zur Stromflussrichtung zwischen den jeweiligen Anschlüssen ermittelt. Insbesondere ist der erste Querschnitt parallel zum zweiten Querschnitt. Zwischen dem ersten Anschluss und dem zweiten Anschluss bezeichnet insbesondere den Teil des Tragkörpers, der sich zwischen den elektrischen Kontaktstellen des ersten Anschluss und des zweiten Anschluss mit dem Tragköper befindet. Der Querschnitt zwischen zwei benachbarten Anschlüssen verringert sich kontinuierlich, wobei der Querschnitt des Tragkörpers im Bereich des ersten Anschlusses kleiner als im Bereich des zweiten und dieser wiederum kleiner als im Bereich des dritten Anschlusses ist. Insbesondere ist der Tragkörper hierbei im Wesentlichen dreieckförmig ausgestaltet, wobei der Querschnitt beispielsweise rechteckförmig ist. Das Dreieck ist vorzugsweise rechtwinklig und eine der beiden Katheten ist länger, insbesondere um mehr als das Doppelte, als die verbleibenden Kathete. Zweckmäßigerweise befinden sich die Kontaktstellen der Anschlüsse an der verlängerten Kathete, und der jeweilige Querschnitt wird vorzugsweise senkrecht zu dieser Kathete ermittelt.

Aufgrund der Verwendung der Stromschiene ist es ermöglicht, eine vergleichsweise kostengünstige Leiterplatte zu verwenden und dennoch vergleichsweise hohe Ströme mittels der elektrischen Schaltung zu schalten. Auch ist die elektrische Schaltung vergleichsweise universell einsetzbar. Zur Anpassung an die zu schaltenden Ströme muss lediglich die Stromtragfähigkeit der Stromschiene und nicht das Layout der Leiterplatte verändert werden. Folglich sind Entwicklungskosten verringert. Ferner sind etwaige Fehlerquellen vermieden, die aufgrund einer Anpassung einer bereits bestehenden Topographie der elektrischen Schaltung auf unterschiedliche Stromstärken entstehen könnten, da lediglich die vergleichsweise robuste, einfache und fehlerunanfällige Stromschiene verändert werden muss. Aufgrund des veränderten Querschnitts des Tragkörpers ist der Materialbedarf der Stromschiene verringert, was zu geringeren Materialkosten und einem verringerten Gewicht führt. Auch ist auf diese Weise eine verbesserte Luftzirkulation zur Leiterplatte gegeben.

Die elektrische Schaltung ist zweckmäßigerweise Bestandteil eines Kraftfahrzeugs und insbesondere eines Nutzfahrzeugs. Geeigneterweise ist hierbei die elektrische Schaltung Bestandteil eines Stromkreises, mittels dessen ein elektrisches Nebenaggregat betrieben wird. Die elektrische Schaltung ist hierbei Bestandteil eines Relais zum Schalten des elektrischen Stroms. Zweckmäßigerweise ist die Stromschiene vorgesehen und eingerichtet, einen elektrischen Strom von über 5 A, 10 A, 20 A, 50 A, 100 A, 150 A, 200 A oder 250 A und bis zu 300 A sicher zu tragen. Geeigneterweise ist die Stromschiene vorgesehen und eingerichtet, einen elektrischen Strom von größer oder gleich 300 A, 350 A, 400 A, 450 A, 500 A oder mehr sicher zu tragen. Beispielsweise ist eine hierbei anliegende elektrische Spannung gleich 12 V, 24 V oder 48 V und vorzugsweise kleiner als 60 V. insbesondere ist die Stromschiene derart ausgelegt, dass bei einem elektrischen Strom mit einer Stromstärke von 300 A und einer elektrischen Spannung von 24 V keine Zerstörung der Stromschiene erfolgt, auch wenn ein derartiger elektrischer Strom über einen vergleichsweise langen Zeitraum anliegt.

Zweckmäßigerweise weist die elektrische Schaltung zwei derartige Stromschienen auf, die mittels zumindest eines Teils der elektrischen/elektronischen Bauelemente miteinander elektrisch kontaktiert sind. Folglich sind diese Bauelemente parallel zueinander geschalten, wobei jedes dieser Bauelemente insbesondere mit den beiden Stromschienen und jeweils einem der Anschlüsse der Stromschienen elektrisch kontaktiert ist, geeigneterweise mittels einer der Leiterbahnen. Hierbei ist insbesondere eines der Bauelemente mit dem ersten Anschluss der einen Stromschiene und mit einem Anschluss der weiteren Stromschiene elektrisch kontaktiert, der nicht der erste Anschluss der weiteren Stromschiene ist. Beispielsweise ist dieses Bauelement mit dem ersten Anschluss der einen Stromschiene und dem dritten Anschluss der weiteren Stromschiene elektrisch kontaktiert. Vorzugsweise sind hierbei der zweite Anschluss der einen Stromschiene und der zweite Anschluss der weiteren Stromschiene sowie der dritte Anschluss der einen Stromschiene und der erste Anschluss der weiteren Stromschiene jeweils mittels eines der Bauelemente elektrisch kontaktiert. Das bzw. die Bauelemente sind hierbei zweckmäßigerweise Halbleiterschalter, z.B. Transistoren und bevorzugt MOSFETs oder IGBTs.

Vorzugsweise ist die Stromschiene einstückig, also die Anschlüsse an dem Tragkörper angeformt. Auf diese Weise ist die Robustheit der Stromschiene erhöht. Zweckmäßigerweise besteht der Tragkörper, und insbesondere die vollständige Stromschiene, aus einem einzigen Material. Mit anderen Worten ist der spezifische Widerstand des Tragkörpers konstant. In Folge dessen ist der elektrische Widerstand des Tragkörpers zwischen dem ersten und dem zweiten Anschluss größer als zwischen dem zweiten und dem dritten Anschluss. Auf diese Weise ist eine Verteilung des elektrischen Stroms auf die Leiterplatte vereinfacht. Geeigneterweise ist die Stromschiene als Stanzbiegeteil ausgeführt, also aus einem Material gestanzt und in eine geeignete Form gebogen. Folglich ist die Herstellung der Stromschiene vergleichsweise kostengünstig. In einer bevorzugten Ausführungsform der Erfindung besteht die Stromschiene aus Kupfer, was zu einem vergleichsweise niedrigen elektrischen Widerstand der Stromschiene und somit zu einer hohen Stromtragfähigkeit führt. Unter Kupfer wird hierbei insbesondere reines Kupfer aber jedoch auch jegliche Kupferlegierung verstanden. Geeigneterweise besteht die Stromschiene aus vernickeltem Kupfer, also einem Kupferkörper, der mit einer Nickelschicht überzogen ist. Auf diese Weise wird eine Oxidation des Kupfers verhindert, und eine elektrische Kontaktierung der Stromschiene ist vereinfacht. Alternativ oder in Kombination hierzu ist die Stromschiene verzinnt und/oder versilbert.

In einer bevorzugten Ausführungsform der Erfindung bildet ein Ende des Tragkörpers die Kontaktierung des ersten Anschlusses, und insbesondere geht der Tragkörper in den ersten Anschluss über. Zweckmäßigerweise ist der erste Querschnitt der kleinste Querschnitt des Tragkörpers und/oder gleich dem Querschnitt des ersten Anschluss. Somit weist der Tragkörper den größten elektrischen Widerstand zwischen dem zweiten und dem ersten Anschluss auf. Beispielsweise weist eines der Enden des Tragkörpers eine Öffnung auf. Die Öffnung ist zweckmäßigerweise rund. Mittels der Öffnung ist eine Befestigungsstelle für ein elektrisches Kabel geschaffen, wobei die Anbindung vergleichsweise robust ist. Vorteilhafterweise ist innerhalb der Öffnung zumindest teilweise ein Gewindebolzen angeordnet, also in die Öffnung eingeführt. Mittels des Gewindebolzens ist insbesondere ein Kabelschuh an dem Tragkörper angebunden. Hierfür wird zweckmäßigerweise mittels des Gewindebolzens und einer Mutter eine kraftschlüssige Verbindung zwischen dem Kabelschuh und dem Tragkörper erstellt. Der Kabelschuh seinerseits ist vorteilhafterweise an einem elektrischen Kabel angebunden und mit diesem elektrisch kontaktiert. Auf diese Weise ist eine vergleichsweise robuste elektrische Kontaktierung der Stromschiene ermöglicht, die vergleichsweise temperaturstabil und zudem lösbar ist. Auch ist für die Herstellung der elektrischen Kontaktierung nur vergleichsweise einfaches und nicht platzintensives Werkzeug erforderlich. Alternativ hierzu weist wird das elektrische Kabel mit der Stromschiene verlötet oder verschweißt.

In einer besonders bevorzugten Ausführungsform der Erfindung weist eines der Enden des Tragkörpers die Öffnung und das verbleibende Ende des Tragkörpers die Kontaktierung des ersten Anschlusses auf, wobei der Tragkörper insbesondere lang gestreckt ist, und die Enden den jeweiligen Abschluss in die Richtung der Erstreckung bezeichnet. Auf diese Weise ist der elektrische Widerstand zwischen dem dritten Anschluss und dem zweiten Anschluss geringer als zwischen dem zweiten Anschluss und dem ersten Anschluss, so dass mittels der Stromschiene eine Widerstandsleiter realisiert ist. Insbesondere besteht die Stromschiene hierbei aus einem einzigen Material und ist vorzugsweise als Stanzbiegeteil ausgeführt. Folglich ist die Widerstandskette ohne weitere elektrische Bauelemente realisiert und vergleichsweise schnell und kostengünstig erstellt.

Erfindungsgemäß umfasst die Stromschiene zumindest einen weiteren Anschluss, der direkt benachbart zu dem dritten Anschluss mit dem Tragkörper elektrisch kontaktiert und insbesondere an diesem angebunden ist. Hierbei ist der dritte Anschluss zwischen dem zweiten Anschluss und dem weiteren Anschluss positioniert. Der Tragkörper weist zwischen dem dritten Anschluss und dem weiteren Anschluss zweckmäßigerweise einen Querschnitt auf, der größer als der zweite Querschnitt ist. Insbesondere weist die Stromschiene eine Anzahl weiterer Anschlüsse auf, die jeweils zueinander benachbart entlang des Tragkörpers mit diesem kontaktiert und insbesondere an diesem angebunden sind. Hierbei weist der Tragkörper zwischen jeweils benachbarten Anschlüssen einen Querschnitt auf, der mit zunehmendem Abstand zu dem ersten Anschluss vergrößert ist. Mit anderen Worten nimmt insbesondere der Querschnitt des Tragkörpers mit zunehmendem Abstand zu dem ersten Anschluss kontinuierlich zu, wobei zwischen benachbarten Anschlüssen der Querschnitt entweder konstant ist oder ebenfalls im Wesentlichen kontinuierlich zunimmt. Jeder der weiteren Anschlüsse ist zudem mit der Leiterplatte kontaktiert, so dass eine Vielzahl von elektrischen Anschlüssen auf der Leiterplatte bereitgestellt ist.

Vorzugsweise ist der Querschnitt jedes der Anschlüsse konstant, wobei der Querschnitt senkrecht zur Stromflussrichtung ermittelt wird. Insbesondere ist der Querschnitt aller Anschlüsse gleich groß und entspricht z.B. dem ersten Querschnitt. In Folge dessen weist jeder Anschluss bei einer Fertigung aus dem gleichen Material jeweils den gleichen elektrischen Widerstand auf. Beispielsweise ist der Abstand zwischen den Kontaktierungen benachbarter Anschlüsse mit dem Tragkörper gleich groß. Mit anderen Worten ist der Abstand zwischen der Kontaktierung des ersten und des zweiten Anschlusses gleich dem Abstand zwischen der Kontaktierung des zweiten und des dritten Anschlusses. Soweit weitere Anschlüsse vorhanden sind, ist hierbei der Abstand zwischen jeweils benachbarten Anschlüssen gleich dem Abstand zwischen der Kontaktierung des ersten Anschlusses und der Kontaktierung des zweiten Anschlusses jeweils mit dem Tragkörper. Auf diese Weise ist eine Handhabung der Stromschiene vereinfacht sowie der elektrische Widerstand zwischen benachbarten Anschlüssen bei geeigneter Materialwahl im Wesentlichen nur von dem Querschnitt des Tragkörpers abhängig.

Beispielsweise weist jeder Anschluss eine Anzahl von Pins auf. Unter Pin wird insbesondere ein zylindrischer Fortsatz verstanden. Geeigneterweise besteht jeder Anschluss aus den jeweiligen Pins oder weist weitere Bestandteile auf, die zwischen den Pins und der Kontaktierung mit dem Tragkörper angeordnet sind. Die Pins sind in entsprechende erste Öffnungen der Leiterplatte gepresst. Insbesondere sind die Ränder der ersten Öffnungen elektrisch leitend und zweckmäßigerweise Bestandteil von zumindest einer Leiterbahn der Leiterplatte. Zwischen jedem Pin und der Begrenzung der Öffnung ist aufgrund des Einpressens eine kraftschlüssige Verbindung realisiert, so dass die elektrische Kontaktierung zwischen dem Anschluss und der Leiterplatte ohne Zuhilfenahme von weiteren Hilfsmitteln, wie z. B. Lot, erfolgt. Aufgrund der Verwendung einer Anzahl von Pins sind diese folglich zueinander elektrisch parallel geschaltet, und die Belastung jedes einzelnen Pins ist verringert, sodass diese vergleichsweise filigran ausgeführt werden können. Insbesondere sind die Pins federnd ausgestaltet, geeigneterweise senkrecht zur Einpressrichtung, was ein Einpressen erleichtert. Ebenfalls ist auf diese Weise ein Toleranzausgleich geschaffen. Insbesondere besteht jeder Pin aus einem Material, das federelastische Eigenschaften aufweist. Z.B. ist jeder Pin unter Bildung zweier paralleler Schenkel geschlitzt, wobei der Schlitz parallel zur Einpressrichtung ist und zweckmäßigerweise an dessen Enden nicht geöffnet. Die Schenkel sind senkrecht zur Einpressrichtung gewölbt oder ausgebuchtet, wobei die Ausbuchtung der beiden Schenkel entgegengesetzt gerichtet ist. Auf diese Weise ist jeder Pin vergleichsweise einfach und kostengünstig federnd ausgestaltet und eine Anbindung an die Leiterplatte erleichtert. Alternativ zum Einpressen sind die Pins innerhalb der entsprechenden ersten Öffnungen der Leiterplatte angelötet und folglich mittels Lot fixiert. Auf diese Weise kann vergleichsweise kostengünstiges Material zur Erstellung der Pins verwendet werden.

Geeigneterweise weist der Tragkörper über dessen gesamte Länge einen L-förmigen Querschnitt auf. Der erste Querschnitt und der zweite Querschnitt ist jeweils L-förmig, wobei insbesondere einer der auf diese Weise gebildeten Schenkel parallel zur plattenförmigen Leiterplatte ist. Auf diese Weise ist einerseits die Bauhöhe der elektrischen Schaltung verringert und andererseits die Stabilität der Stromschiene erhöht. Insbesondere ist der Querschnitt des Tragkörpers im Bereich der Kontaktierungen der Anschlüsse mittels zweier zueinander beabstandeter Schenkel gebildet, die insbesondere senkrecht zueinander angeordnet sind. Mit anderen Worten ist der Bereich des direkten mechanischen Kontakts zwischen den beiden Schenkeln ausgespart. In Folge dessen weist der Tragkörper im Bereich der Kontaktierungen jeweils Aussparungen auf. Mittels der Aussparungen ist ein Ansatzpunkt für ein Werkzeug zum Anbinden der Stromschiene an der Leiterplatte geschaffen.

Insbesondere werden zur Montage der elektrischen Schaltung Bestandteile der Stromschiene in entsprechende Ausnehmungen der Leiterplatte gepresst. Beispielsweise sind die Pins und die ersten Öffnungen vorhanden. Hierbei sind die Pins in Einpressrichtung vor den jeweiligen Aussparungen angeordnet, so dass bei einem Ausüben von Kraft auf die Begrenzung der Aussparung die Pins in die ersten Öffnungen gepresst werden. In Folge dessen wird die Stromschiene bei der Montage an der Leiterplatte nicht verformt. Ferner ist mittels der Aussparungen Material im Bereich des L-förmigen Knicks abgetragen, sodass ein Biegen des Tragekörpers in die L-Form erleichtert ist.

Vorzugsweise weist jeder Anschluss ein Federelement auf, das zwischen der Kontaktierung mit dem Tragkörper und der Leiterplatte angeordnet ist. Somit ist ein Toleranzelement geschaffen, und eine Bewegung des Tragkörpers relativ zur Leiterplatte in einem begrenzten Maß ermöglicht, ohne dass die elektrische Schaltung zerstört wird. Insbesondere bei einer Verwendung im Automobilbereich wird die elektrische Schaltung somit auch bei einer Fahrt über vergleichsweise schlechte Straßen oder bei erprobten Fahrmanövern nicht beschädigt. Insbesondere ist jeder Anschluss L-förmig gebogen und beispielsweise auf diese Weise das jeweilige Federelement realisiert. Zweckmäßigerweise ist einer der Schenkel jedes Anschlusses parallel zur Leiterplatte und liegt zweckmäßigerweise an der Leiterplatte an. Mit anderen Worten ist dieser Schenkel im Wesentlichen über dessen gesamte Länge in direktem mechanischem Kontakt mit der Leiterplatte. Auf diese Weise ist eine vergleichsweise sichere Anbindung der Stromschiene an der Leiterplatte ermöglicht und die Position der Stromschiene bezüglich der Leiterplatte stabilisiert. Auch ist auf diese Weise ein Ansatzbereich für ein Werkzeug zur Montage der Stromschiene an der Leiterplatte geschaffen.

Vorteilhafterweise weist der zur Leiterplatte parallele Schenkel jedes Anschlusses einen Kontaktpin auf, der senkrecht zur Leiterplatte ist und zu diesem weist. Vorteilhafterweise ist jeder Kontaktpin im Montagezustand in jeweils eine korrespondierende zweite Öffnung eingepresst, wobei der Rand der zweiten Öffnung insbesondere elektrisch leitend und geeigneterweise Bestandteil einer Leiterbahn der Leiterplatte ist. Alternativ hierzu erfolgt mittels des Kontaktpins lediglich die mechanische Anbringung des Anschlusses an der Leiterplatte, wohingegen die elektrische Kontaktierung mittels eines weiteren Bereiches des zur Leiterplatte parallelen Schenkels mittels einer Anlage des Schenkels an einer Leiterbahn der Leiterplatte erfolgt. Aufgrund der Parallelität des Schenkels zur Leiterplatte ist ein Einpressen mittels Kraftausübung auf den im Vergleich zur zweiten Öffnung vergrößerten Schenkel vereinfacht. Beispielsweise ist der Querschnitt des Pins parallel zur Leiterplatte quadratisch, wobei die Ecken abgerundet sind. Vorzugsweise ist der Pin hierbei hohl, und Zweckmäßigerweise ist jede Kante geschlitzt, so dass die jeweils abgerundeten Ecken in Richtung des Mittelpunkts biegbar sind. Somit ist bei einer geeigneten Materialwahl mittels elastischer Verbiegung der Ecken vergleichsweise einfach eine kraftschlüssige Verbindung zwischen dem jeweiligen Anschluss und der Leiterplatte hergestellt.

Zweckmäßigerweise ist der Kontaktpin mittels einer Sicke erstellt. Mit anderen Worten wird der Kontaktpin mittels Kraftausübung auf der entgegengesetzten Seite des Schenkels aus diesem heraus gepresst. Auf diese Weise ist der Kontaktpin vergleichsweise einfach erstellt, und der Kontaktpin muss nicht vergleichsweise zeitaufwändig befestigt werden. Auch ist somit eine Anpassung der Stromschiene an die jeweilige Leiterplatte vergleichsweise einfach. Beispielsweise ist der Kontaktpin mittels Prägen erstellt.

Die Stromschiene weist einen Tragkörper sowie einen ersten als auch einen zweiten und einen dritten Anschluss auf. Die Anschlüsse sind jeweils mit dem Tragkörper elektrisch kontaktiert und insbesondere an diesem angebunden. Hierbei ist der zweite Anschluss benachbart zu sowohl dem ersten Anschluss als auch dem dritten Anschluss mit dem Tragkörper kontaktiert. Der erste Anschluss ist nicht direkt benachbart zu dem dritten Anschluss. Vielmehr ist der zweite Anschluss zwischen diesen angeordnet. Die einzelnen Anschlüsse sind parallel zueinander geschaltet. Der Tragkörper weist zwischen dem ersten und dem zweiten Anschluss einen ersten Querschnitt und zwischen dem zweiten und dem dritten Anschluss einen zweiten Querschnitt auf. Hierbei ist der erste Querschnitt kleiner als der zweite Querschnitt. Mit anderen Worten ist die Fläche des ersten Querschnitts kleiner als die Fläche des zweiten Querschnitts, wobei zur Ermittlung der Fläche insbesondere lediglich der Teil des Querschnitts beiträgt, der mit Material befüllt ist. Also derjenige Teil des Tragkörpers, der aus einem Vollmaterial besteht.

Ausführungsbeispiele, von denen die Figuren 1 bis 5 nicht Teil der Erfindung sind, werden nachfolgend anhand einer Zeichnung näher erläutert.

Darin zeigen:
- Fig. 1: perspektivisch eine elektrische Schaltung mit zwei Stromschienen,
- Fig. 2: die elektrische Schaltung in einer Seitenansicht,
- Fig. 3: perspektivisch eine der Stromschienen,
- Fig. 4: Anschlüsse der Stromschiene mit jeweils einem Kontaktpin,
- Fig. 5: eine weitere Ausführungsform des Kontaktpins,
- Fig. 6: perspektivisch eine weitere Ausführungsform der Stromschiene mit jeweils einer Anzahl von Pins aufweisenden Anschlüssen, und
- Fig. 7: einen Anschluss mit einer Anzahl von Pins.

Einander entsprechende Teile sind in allen Figuren mit den gleichen Bezugszeichen versehen.

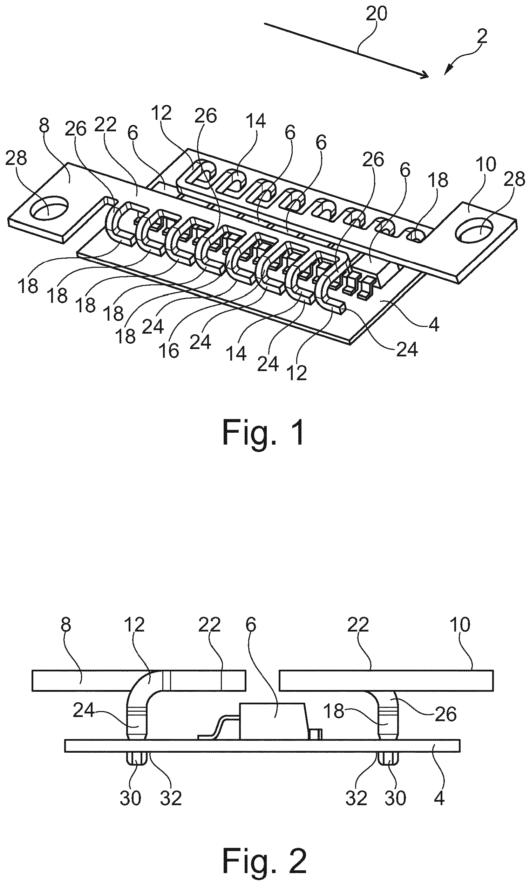

In Fig. 1 ist perspektivisch eine elektrische Schaltung 2 mit einer plattenförmigen Leiterplatte 4 dargestellt. Die Leiterplatte 4 umfasst eine Platte aus einem faserverstärkten Kunststoff, beispielsweise Glasfasergewebe, das in Epoxidharz getränkt ist. Auf der Kunststoffplatte ist eine Kupferschicht aufgebracht, die zur Erstellung von nicht gezeigten Leiterbahnen partiell abgetragen ist. Mit anderen Worten weist die Leiterplatte 4 eine gedruckte Schaltung auf. Die elektrische Schaltung 2 umfasst ferner elektrische Bauelemente 6, von denen acht Transistoren in Form von MOSFETs gezeigt sind. Die elektrische Schaltung 2 weist ferner eine erste Stromschiene 8 und eine zweite Stromschiene 10 auf, die gleich aufgebaut und an der Leiterplatte 4 befestigt sind. Hierbei ist die zweite Stromschiene 10 im Vergleich zur ersten Stromschiene 8 um 180° gedreht positioniert. Jede Stromschiene 8, 10 weist einen ersten Anschluss 12, einen zweiten Anschluss 14, einen dritten Anschluss 16 und fünf weitere Anschlüsse 18 auf, deren Querschnitt gleich ist, und die an einem sich in eine Längsrichtung 20 erstreckenden im Wesentlichen L-förmigen Tragkörper 22 angebunden sind. Jeder Anschluss 12, 14, 16, 18 ist unter Bildung eines ersten Schenkels 24 und eines zweiten Schenkels 26 L-förmig ausgestaltet, wobei jeder erste Schenkel 24 parallel zu der Leiterplatte 4 ist und an diesem anliegt. Alle ersten Schenkel 24 sind gleichartig, weisen also die gleiche Form auf, und in Längsrichtung 20 angeordnet. Mittels der ersten Schenkel 24 sind die Stromschienen 8, 10 einerseits an der Leiterplatte 4 befestigt und andererseits mit dessen Leiterbahnen elektrisch kontaktiert.

Der L-förmigen Tragkörper 22 ist parallel zur Leiterplatte 4 angeordnet und zu dieser beabstandet, wobei der zur Längsrichtung 20 parallele Schenkel auf der dem verbleibenden Schenkel zugewandten Seite eine Treppenstruktur aufweist. Jede Stufe befindet sich hierbei an der Kontaktstelle mit dem jeweiligen zweiten Schenkel 26 der Anschlüsse 12, 14, 16, 18. Der Abstand zwischen benachbarten Anschlüssen 12, 14, 16, 18 und somit auch deren jeweiliger zweiter Schenkel 26 in Längsrichtung 20 ist gleich. Folglich ist die Länge jeder Treppenstufe in Längsrichtung 20 gleich. Zwischen benachbarten Anschlüssen 12, 14, 16, 18 ist der Querschnitt des Tragkörpers 22 senkrecht zur Längsrichtung 20 konstant. Das Freiende des die Treppenstruktur aufweisenden Schenkels des Tragkörpers 22 bildet die Kontaktierung des ersten Anschlusses 12. Der Tragkörper 22 geht somit in den ersten Anschluss 12 über.

Der Tragkörper 22 weist zwischen dem ersten Anschluss 12 und dem zweiten Anschluss 14 einen ersten Querschnitt und zwischen dem zweiten Anschluss 14 und dem dritten Anschluss 16 einen zweiten Querschnitt auf, wobei der erste Querschnitt gleich dem Querschnitt des ersten Anschlusses 12 und kleiner als der zweite Querschnitt ist. Auch nimmt der Querschnitt zwischen dem dritten Anschluss 16 und dem hierzu benachbarten weiteren Anschluss 18 sowie zwischen jeweils benachbarten weiteren Anschlüssen 18 kontinuierlich zu. Folglich ist der Querschnitt des die Treppenstruktur aufweisenden Schenkels im Bereich zum Übergang zum weiteren Schenkel des L-förmigen am Tragkörpers 22 am größten. Der weitere Schenkel weist eine runde Öffnung 28 auf.

Die Stromschienen 8, 10 sind jeweils als Stanzbiegeteil aus verzinktem Kupfer erstellt und weisen folglich einen konstanten spezifischen elektrischen Widerstand auf. Infolgedessen ist der elektrische Widerstand zwischen dem ersten Anschluss 12 und dem zweiten Anschluss 14 größer als der elektrische Widerstand zwischen dem zweiten Anschluss 14 und dem dritten Anschluss 16. Der elektrische Widerstand jedes Anschlusses 12, 14, 16, 18 ist hierbei im Wesentlichen gleich. Folglich ist mittels jeder Stromschiene 8, 10 eine Widerstandskette realisiert. Jeder Anschluss 12, 14, 16, 18 ist mittels einer Leiterbahn der Leiterplatte 4 mit einem der Transistoren 6 elektrisch kontaktiert, wobei der erste Anschluss 12 mittels eines der Transistoren 6 mit dem weiteren Anschluss 18 der zweiten Stromschiene 10 elektrisch kontaktiert ist, dessen Abstand zu der Öffnung 28 am geringsten ist. Der hierzu benachbarte weitere Anschluss 18 der zweiten Stromschiene 10 ist mittels eines weiteren der Transistoren 6 mit dem zweiten Anschluss 14 der ersten Stromschiene 8 elektrisch kontaktiert, usw. Folglich sind die beiden Stromschienen 8, 10 mittels der Transistoren 6 elektrisch verbunden, wobei die Transistoren 6 zueinander parallel geschaltet sind.

Die Ansteuerung der Transistoren 6 erfolgt mittels weiterer Leiterbahnen, wobei bei Betrieb der elektrischen Schaltung 2 entweder sämtliche Transistoren 6 leitend oder nicht leitend geschaltet sind. Alternativ werden lediglich eine bestimmte Anzahl der Transistoren 6 leitend geschaltet. Mittels der elektrischen Schaltung 2 wird ein Nebenaggregat eines Nutzfahrzeugs bestromt, wobei an den beiden Stromschienen 8, 10 eine elektrische Spannung von 24 V anliegt. Der über die beiden Stromschienen 8, 10 fließende elektrische Strom weist eine Stromstärke von 280 A auf. Aufgrund des abnehmenden Querschnitts des Tragkörpers 22 und des somit erhöhten elektrischen Widerstands ist die mittels jedes Anschlusses 12, 14, 16, 18 geführte Stromstärke gleich 35 A.

In Fig. 2 ist die elektrische Schaltung 2 in einer Seitenansicht in Längsrichtung 20 dargestellt. Zwischen dem Tragkörper 22 und der Leiterplatte 4 befinden sich die Transistoren 6, die somit mittels der Stromschienen 8, 10 und der Leiterplatte 4 vor einer Beschädigung geschützt werden. In einer hierzu alternativen, nicht dargestellten Ausführungsform ist die Leiterplatte 4 zwischen dem Tragkörper 22 zumindest einer der Stromschienen 8, 10 angeordnet. An jedem zur Leiterplatte 4 parallelen Schenkel 24 jedes Anschlusses 12, 14, 16, 18 ist jeweils ein Kontaktpin 30 angebunden, der in eine jeweils korrespondierende zweite Öffnung 32 der Leiterplatte 4 eingepresst ist. Zur Montage setzt hierbei ein geeignetes Werkzeug an dem jeweiligen ersten Schenkel 24 an und drückt die jeweilige Stromschiene 8, 10 gegen die Leiterplatte 4, sodass eine kraftschlüssige Verbindung zwischen den Kontaktpins 30 und der jeweils zugeordneten zweiten Öffnung 32 erstellt wird. Mittels des senkrecht zur Längsrichtung 20 angeordneten Kontaktpins 30 wird hierbei ebenfalls die elektrische Kontaktierung erstellt.

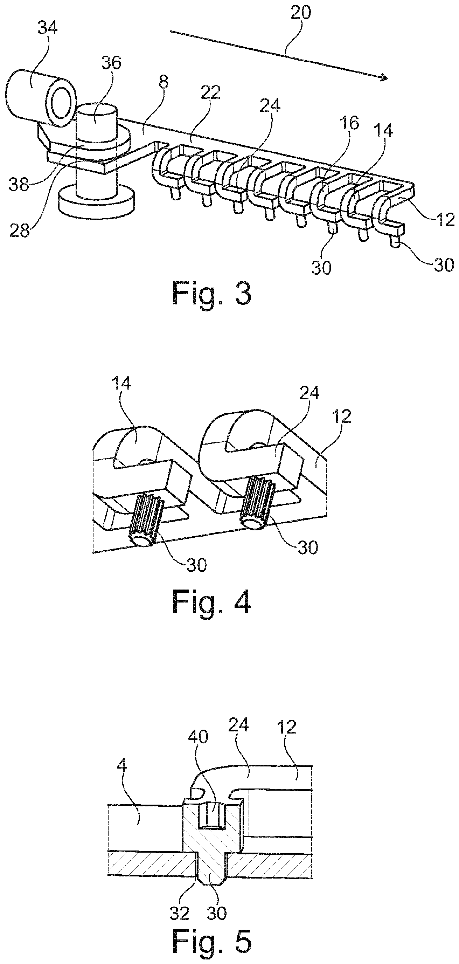

In Fig. 3 ist die erste Stromschiene 8 im unmontierten Zustand dargestellt. Mit anderen Worten sind die Kontaktpins 30 nicht an der Leiterplatte 4 befestigt. An der ersten Stromschiene 8 ist ein Kabelschuh 34 mittels eines Gewindebolzens 36 angebunden, wobei die Befestigung mittels einer hier nicht gezeigten Mutter erfolgt, die auf das Freiende des Gewindebolzens 36 aufgedreht wird. Der Gewindebolzen 36 ist teilweise innerhalb der Öffnung 28 des Tragkörpers 22 positioniert und ragt weiterhin durch eine korrespondierende Öffnung 38 des Kabelschuhs 34. Mittels der Mutter und dem Gewindebolzen 36 wird im Montagezustand eine kraftschlüssige Verbindung zwischen dem Kabelschuh 34 und der ersten Stromschiene 8 erstellt, wobei ein Freiende eines Kabels mit dem Kabelschuh 34 elektrisch kontaktiert ist. Auf diese Weise ist eine vergleichsweise niederohmige und erneut lösbare Verbindung zwischen dem Kabel und der ersten Stromschiene 8 geschaffen.

In Fig. 4 ist perspektivisch ausschnittsweise die erste Stromschiene 8 an deren der Öffnung 28 gegenüberliegendem Freiende dargestellt. Jeder Kontaktpin 30 weist eine Riffelung auf. Mit anderen Worten ist der Querschnitt jedes Kontaktpins 30 parallel zur Leiterplatte 4 sternförmig. Beim Einpressen der Kontaktpins 30 in die zweiten Öffnungen 32 wird die Oberflächenstruktur der jeweiligen Kontaktpins 30 mittels der zweiten Öffnungen 32 plastisch und/oder elastisch verformt, was zu einer kraftschlüssigen Verbindung zwischen diesen führt.

In Fig. 5 ist eine weitere Ausführungsform des zweiten Schenkels 24 in einer Schnittdarstellung parallel zur Längsrichtung 20 und senkrecht zur Leiterplatte 4 gezeigt, wobei hier lediglich der erste Anschluss 12 dargestellt ist. Der Kontaktpin 30 ist mittels einer Sicke 40 erstellt. Mit anderen Worten wird der zweite Schenkel 24 mittels eines geeigneten Werkzeugs zur Erstellung der Sicke 40 geprägt.

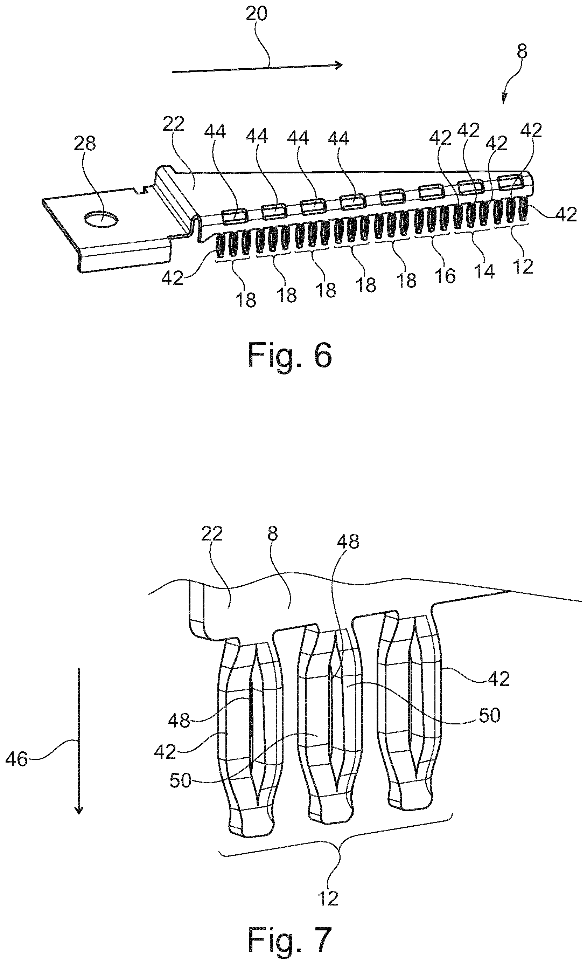

In Fig. 6 ist eine weitere Ausführungsform der ersten Stromschiene 8 perspektivisch dargestellt. Bei einer Montage der ersten Stromschiene 8 an der Leiterplatte 4 wird für die zweite Stromschiene 10 ebenfalls diese Ausführungsform gewählt, wobei die zweite Stromschiene 10 wiederum um 180° gedreht positioniert wird. Auch ist die Kontaktierung der Transistoren 6 ebenfalls die gleiche. Mit anderen Worten ist im Vergleich zu der in Fig. 1 gezeigten Ausführungsform der elektrischen Schaltung 2 lediglich die erste und zweite Stromschiene 8, 10 sowie deren Anbindung an der Leiterplatte 4 verändert.

Die erste Stromschiene 8 umfasst wiederum den Tragkörper 22, der im Wesentlichen dreieckförmig ausgestaltet ist. Die Dreiecksform ist im Montagezustand parallel zur Leiterplatte 4 angeordnet. Das Dreieck ist rechtwinklig, wobei eine der Katheten parallel zur Längsrichtung 20 und die verbleibende Kathete senkrecht zur Längsrichtung 20 ist. Die Länge der Kathete parallel zur Längsrichtung 20 ist das Dreifache der Länge der verbleibenden Kathete. Hierbei ist die sich in Längsrichtung 20 erstreckende Kante um 90° in Richtung der Leiterplatte 4 abgewinkelt, so dass der Querschnitt des Tragkörpers 22 senkrecht zur Längsrichtung 20 L-förmig ist. Mit dem abgewinkelten Bereich des Tragkörpers 22 sind der erste Anschluss 12, der zweite Anschluss 14, der dritte Anschluss 16 sowie die fünf weiteren Anschlüsse 18 elektrisch kontaktiert und an diesem angebunden.

Jeder Anschluss 12, 14, 16, 18 ist mittels dreier Pins 42 gebildet (Fig. 7). Im Bereich jedes Anschlusses 12, 14, 16, 18 weist der Tragkörper 22 entlang der abgewinkelten Kante rechteckförmige Aussparungen 44 auf. Infolgedessen ist der Querschnitt des Tragkörpers 22 senkrecht zur Längsrichtung 20 im Bereich der Anschlüsse 12, 14, 16, 18 mittels zweier zueinander beabstandeter und senkrecht zueinander angeordneter Schenkel gebildet. In dem Bereich, der frei von den Aussparungen 44 ist, ist der Querschnitt des Tragkörpers 22 L-förmig, wobei die Länge des Schenkels, der im Montagezustand parallel zur Leiterplatte 4 ist, mit zunehmendem Abstand zum ersten Anschluss 12 zunimmt. Mit anderen Worten ist der erste Querschnitt, der zwischen dem ersten Anschluss 12 und dem zweiten Anschluss 14 gebildet ist, kleiner als der zweite Querschnitt, der zwischen dem zweiten Anschluss 14 und dem dritten Anschluss 16 gebildet ist. An der kürzeren Kathete der Dreiecksform des Tragkörpers 22 ist ein die Öffnung 28 aufweisendes Rechteck mit ebenfalls einer abgewinkelten Kante angeformt. An der Rechteckform ist im Montagezustand wiederum der Kabelschuh 34 mittels des Gewindebolzens 36 angebunden. Die erste Stromschiene 8 ist ebenfalls wiederum einstückig als Stanzbiegeteil aus verzinntem Kupfer erstellt.

In Fig. 7 ist perspektivisch ausschnittsweise das der Öffnung 28 gegenüber liegende Freiende der ersten Stromschiene 8 mit dem ersten Anschluss 12 dargestellt. Der erste Anschluss 12 umfasst die drei Pins 42, die im Wesentlichen senkrecht zur Längsrichtung 20 und senkrecht zur Leiterplatte 4 in eine Einpressrichtung 46 verlaufen. Ein Freiende jedes Pins 42 ist an dem Tragkörper 22 angebunden und einstückig mit diesem. Zudem ist jeder der gleich gefertigten Pins 42 geschlitzt und weist folglich einen Schlitz 48 auf, wobei die Freienden jedes Pins 42 sind frei von dem Schlitz 48 sind. Mittels des Schlitzes 48 sind zwei Schenkel 50 gebildet, die C-förmig gebogen sind. Hierbei ist die Wölbung der beiden Schenkel 50 jedes Pins 42 entgegen gesetzt, so dass die Ausdehnung der Pins 42 senkrecht zur Einpressrichtung 46 und senkrecht zur Längsrichtung 20 im Vergleich zur Dicke des Tragkörpers 22 vergrößert ist. Mittels der Schenkel 50 ist eine Elastizität der Pins 42 geschaffen. Im Montagezustand liegt jeder Pin 42 innerhalb einer ersten Öffnung der Leiterplatte 4. Hierbei werden die Schenkel 50 mittels der ersten Öffnung aufeinander zu gepresst, also deren Wölbung verringert. In Folge dessen ist eine kraftschlüssige Verbindung zwischen den Pins 42 und den ersten Öffnungen geschaffen.

### Bezugszeichenliste

- 2: elektrische Schaltung
- 4: Leiterplatte
- 6: Transistor
- 8: erste Stromschiene
- 10: zweite Stromschiene
- 12: erster Anschluss
- 14: zweiter Anschluss
- 16: dritter Anschluss
- 18: weiterer Anschluss
- 20: Längsrichtung
- 22: Tragkörper
- 24: erster Schenkel
- 26: zweiter Schenkel
- 28: Öffnung
- 30: Kontaktpin
- 32: zweite Öffnung
- 34: Kabelschuh
- 36: Gewindebolzen
- 38: Öffnung
- 40: Sicke
- 42: Pin
- 44: Aussparung
- 46: Einpressrichtung
- 48: Schlitz
- 50: Schenkel

## Patentansprüche

1. Elektrische Schaltung (2) mit einer Leiterplatte (4), auf dem eine Anzahl elektrischer und/oder elektronischer Bauelemente (6) montiert ist, und mit einer einen Tragkörper (22) und einen ersten, zweiten und dritten Anschluss (12, 14, 16) aufweisenden Stromschiene (8, 10), deren Tragkörper (22) von der Leiterplatte (4) beabstandet ist, und deren Anschlüsse (12, 14, 16) sowohl mit dem Tragkörper (22) als auch mit der Leiterplatte (4) elektrisch kontaktiert sind, wobei der Tragkörper (22) zwischen dem ersten und dem zweiten Anschluss (12, 14) einen ersten Querschnitt und zwischen dem zweiten und dem dritten Anschluss (14, 16) einen zweiten Querschnitt aufweist, wobei der erste Querschnitt kleiner als der zweite Querschnitt ist, wobei der jeweilige Querschnitt senkrecht zur kürzesten Verbindung und/oder senkrecht zur Stromflussrichtung zwischen den jeweiligen Anschlüssen (12, 14, 16) ist, wobei die Stromschiene (8, 10) eine Anzahl weiterer Anschlüsse (18) umfasst, wobei der Tragkörper (22) zwischen jeweils benachbarten Anschlüssen (18) einen Querschnitt aufweist, wobei jeder Querschnitt mit zunehmendem Abstand zum ersten Anschluss (12) vergrößert ist, **dadurch gekennzeichnet dass** der erste Querschnitt und der zweite Querschnitt jeweils L-förmig ist.

2. Elektrische Schaltung (2) nach Anspruch 1,
**dadurch gekennzeichnet,**
**dass** die Stromschiene (8, 10) einstückig ist und/oder aus Kupfer besteht.

3. Elektrische Schaltung (2) nach Anspruch 1 oder 2,
**dadurch gekennzeichnet,**
**dass** eines der Enden des Tragkörpers (22) die Kontaktierung des ersten Anschlusses (12) ist, und/oder dass eines der Enden des Tragkörpers (22) eine Öffnung (28) aufweist, mittels dessen ein Kabelschuh (34) an dem Tragkörper (22) angebunden werden kann.

4. Elektrische Schaltung (2) nach einem der Ansprüche 1 bis 3,
**dadurch gekennzeichnet,**
**dass** der Querschnitt der Anschlüsse (12, 14, 16) gleich ist, und/oder dass der Abstand zwischen den Kontaktierungen benachbarter Anschlüsse (12, 14, 16) gleich ist.

5. Elektrische Schaltung (2) nach einem der Ansprüche 1 bis 4,
**dadurch gekennzeichnet,**
**dass** jeder Anschluss (12, 14, 16) eine Anzahl von Pins (42) aufweist, die in erste Öffnungen der Leiterplatte (4) gepresst sind.

6. Elektrische Schaltung (2) nach einem der Ansprüche 1 bis 5,
**dadurch gekennzeichnet,**
**dass** der Querschnitt des Tragkörpers (22) im Bereich der Kontaktierungen der Anschlüsse (12, 14, 16) zwei zueinander beabstandete Schenkel sind.

## Claims

1. Electrical circuit (2) having a circuit board (4), on which a number of electrical and/or electronic components (6) is mounted, and having a bus bar (8, 10) having a supporting body (22) and a first, second and third connection (12, 14, 16), the supporting body (22) of which is spaced apart from the circuit board (4), and the connections (12, 14, 16) of which are electrically contacted both by the supporting body (22) and also by the circuit board (4), wherein the supporting body (22) has a first cross section between the first and the second connection (12, 14) and a second cross section between the second and the third connection (14, 16), wherein the first cross section is smaller than the second cross section, wherein the respective cross section is perpendicular to the shortest connection and/or perpendicular to the current flow direction between the respective connections (12, 14, 16), wherein the bus bar (8, 10) comprises a number of further connections (18), wherein the supporting body (22) has a cross section between respectively adjacent connections (18), wherein each cross section is enlarged with increasing distance from the first connection (12), **characterized in that** the first cross section and the second cross section are each L-shaped.

2. Electrical circuit (2) according to Claim 1, **characterized in that** the bus bar (8, 10) is in one piece and/or consists of copper.

3. Electrical circuit (2) according to Claim 1 or 2, **characterized in that** one of the ends of the supporting body (22) is the contact of the first connection (12), and/or **in that** one of the ends of the supporting body (22) has an opening (28), by means of which a cable terminal (34) can be attached to the supporting body (22) .

4. Electrical circuit (2) according to one of Claims 1 to 3,
**characterized in that** the cross section of the connections (12, 14, 16) is the same, and/or **in that** the distance between the contacts of adjacent connections (12, 14, 16) is the same.

5. Electrical circuit (2) according to one of Claims 1 to 4,
**characterized in that** each connection (12, 14, 16) has a number of pins (42), which are pressed into first openings in the circuit board (4).

6. Electrical circuit (2) according to one of Claims 1 to 5,
**characterized in that** the cross section of the supporting body (22) in the area of the contacts of the connections (12, 14, 16) is two legs spaced apart from one another.

## Revendications

1. Circuit électrique (2) comprenant une carte de circuit imprimé (4) sur laquelle est monté un certain nombre de composants électriques et/ou électroniques (6), et des barres conductrices (8, 10) qui comportent un corps de support (22) et des première, deuxième et troisième bornes (12, 14, 16) et dont le corps de support (22) est espacé de la carte de circuit imprimé (4) et dont les bornes (12, 14, 16) sont en contact électrique aussi bien avec le corps de support (22) qu'avec la carte de circuit imprimé (4), le corps de support (22) ayant une première section transversale entre la première et la deuxième borne (12, 14) et une deuxième section transversale entre la deuxième et la troisième borne (14, 16), la première section transversale étant inférieure à la deuxième section transversale, la section transversale respective étant perpendiculaire à la liaison la plus courte et/ou perpendiculaire à la direction de circulation du courant entre les bornes respectives (12, 14, 16), la barre conductrice (8, 10) comprenant un certain nombre d'autres bornes (18), le corps de support (22) ayant une section transversale entre des bornes adjacentes (18), chaque section transversale augmentant à mesure que la distance à la première borne (12) augmente, **caractérisé en ce que** la première section transversale et la deuxième section transversale sont chacune en forme de L.

2. Circuit électrique (2) selon la revendication 1,
**caractérisé en ce que**
la barre conductrice (8, 10) est d'une seule pièce et/ou en cuivre.

3. Circuit électrique (2) selon la revendication 1 ou 2,
**caractérisé en ce que**
l'une des extrémités du corps de support (22) est le contact de la première borne (12), et/ou **en ce que** l'une des extrémités du corps de support (22) comporte une ouverture (28) au moyen de laquelle une cosse de câble (34) peut être reliée au corps de support (22).

4. Circuit électrique (2) selon l'une des revendications 1 à 3,
**caractérisé en ce que**
la section transversale des bornes (12, 14, 16) est la même et/ou **en ce que** la distance entre les contacts de bornes adjacentes (12, 14, 16) est la même.

5. Circuit électrique (2) selon l'une des revendications 1 à 4,
**caractérisé en ce que**
chaque borne (12, 14, 16) comporte un certain nombre de broches (42) qui sont enfoncées dans des premières ouvertures de la carte de circuit (4).

6. Circuit électrique (2) selon l'une des revendications 1 à 5,
**caractérisé en ce que** la section transversale du corps de support (22) dans la zone des contacts des bornes (12, 14, 16) sont deux branches espacées l'une de l'autre.
